# EUROPEAN PATENT SPECIFICATION

(11) **EP 1 542 287 B1**
(45) Date of publication and mention of the grant of the patent: **01.02.2012**
(21) Application number: 03028319.6
(22) Date of filing: 09.12.2003
(51) Int. Cl.: H01L 29/08, H01L 29/10

(54) **High-frequency bipolar transistor**
Hochfrequenz Bipolartransistor
Transistor bipolaire à haute fréquence

(43) Date of publication of application: 15.06.2005
(73) Proprietor: Infineon Technologies AG, 85579 Neubiberg (DE)
(72) Inventor: Losehand, Reinhard, 80637 München (DE)
(74) Representative: Schoppe, Fritz

(56) References cited:
- GB-A- 2 130 006
- US-A- 2 806 983
- US-A- 5 969 402

## Description

The present invention relates generally to a high-frequency switching transistor and particularly to a high-frequency transistor, which is known for a lower gating voltage than high-frequency transistors according to the prior art.

It is the object of high-frequency switches to forward or block high-frequency signals. In the forward case, they should be characterized by an ohmic resistance, which is as small as possible, and in the blocking case, by a constant capacity, which is as small as possible. They can be realized by different types of circuit elements. In the integrated circuit technology, high-frequency switches are often realized by using a silicon substrate. Thereby, generally, the two types of bipolar or MOS transistor can be formed. In the case of a silicon bipolar transistor, the forward case can be easily realized, if it is operated with a sufficiently large emitter base current in the triode area of the characteristic curve, far below the collector current saturation. At a correct transistor dimensioning, this control current can remain smaller than 1 mA. The blocking case causes more difficulties, since a base and substrate bias voltage, respectively, is required in the off-state, which is as high as the high-frequency amplitude to be blocked. In other words, it can be noted that a base emitter bias voltage has to be applied in the blocking direction with an amount of at least the amplitude of the high-frequency signal, so that the collector base diode is not controlled in the flow direction. Thereby, the switchable power is limited by the available bias voltage.

In battery-operated mobile radio systems, for example, this leads to the problem that a required bias voltage of about 20 volt is much higher than an operating voltage of the mobile radio system of, for example, 2.8 volt.

High-frequency switches for higher powers are realized outside the RF-ICs (RF-IC= radio frequency integrated circuits) in the form of PIN diodes or GaAs transistor switches, which can be operated with lower and no bias voltage, respectively. A disadvantage, however, is the higher cost which can occur due to the additional components.

Another disadvantage of PIN diodes as high-frequency switches is that PIN diodes require a partly higher switching time, which makes their usage in the high and highest frequency technique, respectively, problematic.

GB 2 130 006 A discloses a bipolar semiconductor device comprising two regions of the same type of conductivity, one of which serves as a collector region and the other as an emitter region. A base region is interposed between the former and the latter and connected to a region intended to isolate the collector region from the emitter region. At least one junction region is provided in the collector region and/or the emitter region. The conductivity type of the injection region corresponds to that of the base region. The distance between the rejection region and the base region is I₁ larger than I₂, where I₁ is a distance equal to 1 + 2 diffusion length of minority charge carriers in the collector and emitter regions, where the injection region is found and I₂ is a minimum distance for specified breakdown voltage between the injection region and the base region. A contact window is provided in the passivating layer over the injection region. Through this window, the injection region is connected to a metal control contact.

US 2,806,983 discloses an amplifying asymmetrically-conductive device comprising a monocrystalline waver of semiconductive material having therein first and second spaced zones of one-conductivity type semiconductive material separated by and contiguous with a third zone of opposite-conductivity type semiconductive material, the interface between said third zone and said first and second zones comprising ground P-N junctions, a mass of opposite conductivity-type including activator impurity fused to any alloyed with a surface region of said first zone and producing therein a fuse P-N junction, said fused junction being located within one diffusion length of said third zone, a first electrode conducting said mass of activator material, a second electrode contacting said first zone, and in close proximity to said first electrode and a third electrode contacting said second zone.

US 5,969,402 discloses a semiconductor device and a method of making the semiconductor device, the semiconductor device having a base region, wherein the base region is surrounded by a slot. The sideways depletion region of the collector-based junction terminates on the slot, thus reducing the side ways spreading off the collector-based depletion region.

Starting from this prior art, it is the object of the present invention to provide a high-frequency switch with a low bias voltage, a low switching time as well as switching possibility for high powers.

This object is achieved by a high-frequency switching transistor according to claim 1.

The present invention provides a high-frequency switching transistor, comprising:
a collector area having a first conductivity type;
a first barrier area bordering on the collector area, having a second conductivity type, which differs from the first conductivity type;
a semiconductor area bordering on the first barrier area, which has a dopant concentration which is smaller than a dopant concentration of the first barrier area or equal to zero;
a second barrier area bordering on the semiconductor area, which has the first conductivity type;
a base area bordering on the second area, which has the second conductivity type;
a third barrier area bordering on the semiconductor area, which has the second conductivity type and a higher dopant concentration than the semiconductor area; and
an emitter area bordering on the third barrier area, which has the first conductivity type.

The present invention is based on the knowledge that by applying a predefined blocking voltage between the emitter area and the base area or the base area and the collector area, the semiconductor area can become almost free of charge carriers. Particularly the first and third barrier area contribute to this, which avoid a "flowing in" of charge carriers into the semiconductor area when the blocking voltage is applied. By such an application of the blocking voltage between the emitter and the base, a blocking potential can be built up in the semiconductor area. In order to be able to overcome this blocking potential, a voltage has to be used between the collector and the emitter, which is significantly higher than the switching voltage to be applied between emitter and base for blocking the switching transistor. By such a design, a high-frequency switch can be realized, which can be blocked by a low switching voltage (i.e. blocking voltage), wherein high-frequency signals applied between the emitter and the collector can be blocked with a high voltage amplitude. It is therefore an advantage that the high-frequency switching transistor merely requires a low bias voltage (i.e. switching or blocking voltage) for the switching operation, and thereby high powers are switchable between emitter and collector.

Further, it can be avoided by the second barrier area bordering on the base area, that charge carriers flow back into the semiconductor area between emitter and base despite the applied blocking voltage. Thereby, it is ensured that the blocking potential remains unchanged at applied blocking voltage between emitter and base, independent of a voltage applied between emitter and collector.

Further, the base area and the second barrier area bordering on the base area can be disposed in a predefined distance from the emitter area and the third barrier area bordering on the emitter area, so that by the space charge region being formed, the blocking potential is almost fully reduced already at small forward voltages. This has the further advantage that the switching voltage can be set in a defined way by a free choice of the distance and that the turn-on process in the inventive approach has a significantly lower turn-on delay than prior art approaches.

A preferred embodiment of the present invention will be discussed below with reference to the accompanying drawings. They show:
- Fig. 1: an embodiment of an inventive high-frequency switching transistor in cross-sectional view;
- Fig. 2a to 2c: an illustration of several simulation diagrams of an emitter area cross section of the embodiment of the inventive high-frequency switching transistor illustrated in Fig. 1;
- Fig. 3a to 3c: an illustration of several simulation diagrams of a base contact area cross section of the high- frequency switching transistor illustrated in Fig. 1; and
- Fig. 4: an illustration of several simulation diagrams with regard to an area between emitter and base of the high-frequency switching transistor illustrated in Fig. 1.
- Fig. 5a to 5b: a further embodiment of an inventive high- frequency switching transistor in cross-sectional view;

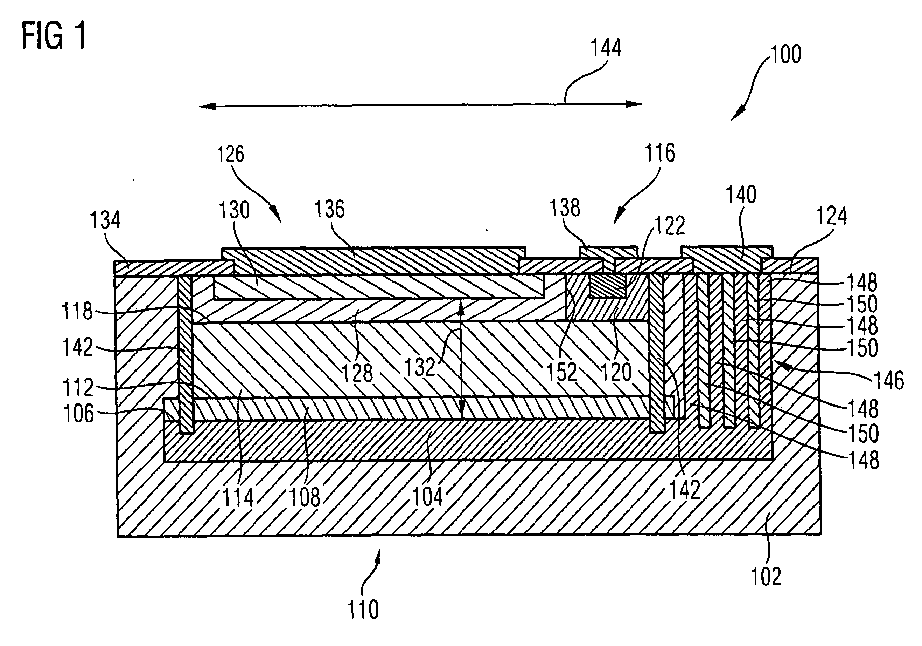

Fig. 1 shows an embodiment of the inventive high-frequency switching transistor. The high-frequency switching transistor 100 comprises a semiisolating substrate 102, into which a collector area 104 is embedded. The collector area 104 has, for example, an n-doped semiconductor material with an n⁺ dopant concentration which is high compared to the semi-isolating substrate 102 (i.e. it is a so-called buried layer n cathode). The dopant concentration of the semiconductor area in the collector area 104 preferably comprises more than 10¹⁹ dopant atoms per cm³. Further, the collector area 104 forms the collector of the high-frequency switching transistor 100. Further, a first barrier area 108 is disposed on a surface 106 of the collector area 104, which preferably comprises a p-doped semiconductor material. In a central area 110 of the high-frequency switching transistor 100, a semiconductor area 114 is disposed on a surface 112 of the first barrier area 108, which preferably comprises a p-doped semiconductor material. However, the dopant concentration of the semiconductor area 114 is thereby lower than the dopant concentration of the first barrier area 108. Preferably, the dopant concentration of the first barrier area 108 is between 10¹⁶ and 10¹⁷ dopant atoms per cm³, however, the dopant concentration of the first barrier area 108 can also lie within a range of values of 10¹⁵ to 10¹⁸ dopant atoms per cm³. The dopant concentration of the semiconductor area, on the other hand, is preferably smaller than 10¹⁴ dopant atoms per cm³.

Further, the first barrier area 108 has preferably a thickness between the surface 106 of the collector area 104 and the surface 112 of the first barrier area 108, which lies within a range of values between 0.2 µm and 1 µm. Alternatively, however, the thickness of the first barrier area can also lie within a range of values between 0.1 µm and 2 µm.

Further, a second barrier area 120 is disposed in a portion 116 of a surface 118 of the semiconductor area 114. The second barrier area 120 preferably comprises an n-doped semiconductor material. Further, a base area 122 is embedded in the second barrier area 120. With regard to the dopant concentration and the thickness of the second barrier area 120 between the surface 118 of the semiconductor area and the base area 122, the statements of the first barrier area 108 hold true analogously. Further, the base area 122 is embedded in the second barrier area 120, such that a flush termination with a second barrier area 120 results on the surface 124.

Further, a third barrier area 126 is disposed in a portion 126 of the surface 118 of the semiconductor area 114. The third barrier area 126 comprises again preferably a p-doped semiconductor material. An emitter area 130 is disposed in a third barrier area 128 such that a flush termination results between the third barrier area 128 and the emitter area 130 on the surface 124. With regard to the dopant concentration of the third barrier area 128, as well as the thickness of the third barrier area 128 between the surface 118 of the semiconductor area 114 and the emitter area 130, the statements with regard to the first barrier area 108 hold true analogously.

The thickness of the semiconductor area 114 between the surface 112 of the first barrier area 108 and the surface 118 of the semiconductor area 114 lies preferably within a range of values between 5 µm and 8 µm. Alternatively, the thickness of the semiconductor area 114 can also lie within a range of values between 4 µm and 10 µm. Therefrom, a distance 132 of 8 µm can result between the collector area 104 and the emitter area 130.

Further, an isolating cover layer 134 is disposed on the surface 124. The isolating cover layer 134 has an opening for contacting the emitter area 130 through an emitter contact structure 136, an opening for contacting the base area 122 with the assistance of a base contact structure 138 as well as an opening for contacting the collector area 104 via a collector contact structure 140. Further, the high-frequency switching transistor 100 has a boundary structure 142, which limits the semiconductor area 114 as well as the third barrier area 128 on the left side and the semiconductor area 114 as well as the second barrier area 120 on the right side. The boundary structure 142 preferably comprises an isolating material and terminates in a flush way with the second barrier area 120 and the third barrier area 128 on the surface 124. Further, the boundary structure 142 projects into the first barrier area 108 as well as the collector area 104. Thus, a lateral extension 144 of the semiconductor area 114, the second barrier area 120 as well as the third barrier area 128 is defined by the boundary structure 142. The lateral extension 144 lies preferably within a range of values between 20 µm and 200 µm. Further, the high-frequency switching transistor 100 can also be formed two-dimensionally, whereby the boundary structure defines a volume, which has substantially a square base, which is disposed in parallel to a main area of the first barrier area 108, and has a base area side edge, which is maximally the lateral extension 144. The base area would further be perpendicular to the drawing level of Fig. 1.

Further, outside the area with the lateral extension 144 defined by the boundary structure 142, a contacting structure 146 is disposed. The contacting structure 146 has conductive areas 148 and isolating areas 150. The conductive areas 148 of the contacting structure 146 enable further an electrically conductive connecting of the collector contact area 140 to the collector area 104. Thereby it is possible to contact the collector area 104 via the collector contacting area 140 conductively, wherein the collector contacting area 140 is disposed higher over the collector area 104 as for example a boundary area between the second barrier area 120 and the base area 122.

Further, the second barrier area 120 can be disposed in a predefined distance 152 from the third barrier area 128. In Fig. 1, the predefined distance 152 between the second barrier area 120 and the third barrier area 128 has a value of zero, the predefined distance 152, however, can be up to 20 µm.

Thus, Fig. 1 shows the cross section of a structure of an integrable npn bipolar transistor, which is optimized for circuit applications. A buried layer (collector area 104) with trench sinker (contacting structure 146) is used, by which the collector area 104 can be contacted from the surface 124 by using the collector contacting area 140. The high-frequency switching transistor 100 is further surrounded by a trench (boundary structure 142), which prevents a coupling to a possibly bordering (in Fig. 1 not shown) high-frequency switching transistors by minority carrier injection. An emitter base collector doping profile contains a low n- (or p-)doped, almost intrinsic base I zone (semiconductor area 114). A higher p-doping is introduced directly at the emitter area 130 and at the collector area 104, (first barrier area 108 as well as a third barrier area 128), which form barriers against electron emission from the respective bordering collector area 104 as well as the emitter area 130 into the semiconductor area 114. Thereby, the blocking ability of the high-frequency switching transistor 100 is effected. A base contact is formed in the intrinsic base area (i.e. in the semiconductor area 114), whereby the second barrier area 120 as well as the base area 122 embedded in the second barrier area 120 result. The base area 122, which comprises a p-doped semiconductor material is further surrounded by an n-doped zone (i.e. the second barrier area 120), which forms a barrier against hole emission.

Thus, according to the embodiment of the inventive high-frequency switching transistor illustrated in Fig. 1, an n-doped semiconductor material forms the first conductivity type, and a p-doped semiconductor material forms the second conductivity type. Thereby, the base area 122 obtains the property that it can receive holes at a negative voltage against the emitter or collector, but returns them at positive polarity only when reaching a threshold voltage. This threshold voltage depends on the formation of a space charge region between the emitter area 130 and the base area 122 (and between the third barrier area 128 and the second barrier area 120, respectively) (emitter injection threshold voltage). This space charge region is, among other things, dependent on the predetermined distance 152 between the second barrier area 120 and the third barrier area 128. Further, an injection threshold voltage between the base area 122 and the collector area 104 has to be considered, which is again formed by a space charge region between the first barrier area 108 and the second barrier area 120. Above that, a collector emission threshold voltage has to be considered, which is effected by a space charge region formation between the first barrier area 108 and the third barrier area 128. Thus, by choosing the respective distances between the first barrier area 108, the second barrier area 120 and the third barrier area 128 (i.e. by an appropriate structure of the high-frequency switching transistor 100 illustrated in Fig. 1), it can be achieved that the emitter injection threshold voltage is small (such as 2.5 volt), while the collector emission threshold voltage is high (such as 20 volt). Below the respective emission threshold voltages, the turn on procedure is delayed so much by forming space charge regions in the barrier areas that no remarkable current flows in flow direction at short-term controlling.

Further, the high-frequency switching transistor 100 can be built in a high-frequency circuit, which is not illustrated here. The high-frequency circuit can comprise a control circuit, which is formed to open or close the switch with the high-frequency switching transistor depending on a control signal, wherein the control means is formed to apply a negative switching voltage between the barrier area and the emitter area for closing the switch. Thereby, the switch can have a switch input (such as the collector area of the high-frequency switching transistor), which can be coupled to a high-frequency source. A voltage signal can be supplied from the high-frequency source, which has a high-frequency voltage amplitude, and wherein the switching voltage is smaller or equal to half the high-frequency voltage amplitude. Thus, in the blocking case, the transistor endures high-frequency voltage amplitudes of, for example, up to 20 volt between the collector area 104 and the emitter area 130, but can be switched to the on-state by the control circuit with a base emitter voltage of more than 2.5 volt.

In order to switch back to the off-state, the high-frequency switching transistor requires a negative base emitter voltage, which is so high that almost all charge carriers (such as electrons or holes) can be removed from the base area (i.e. particularly from the semiconductor area 114). The base emitter voltage depends particularly on the doping in the first barrier area 108, the second barrier area 120 as well as the third barrier area 128 and can be set such that it is about 2.5 volt. Thus, circuits (particularly a high-frequency switching transistor 100) can be realized, which can switch the high-frequency switching transistor on and off with supply voltages (switching voltages) of about slightly over 2.5 volt.

Still, the high-frequency amplitude of a high-frequency signal to be switched can be significantly higher than the switching voltage (such as 20 volt.).

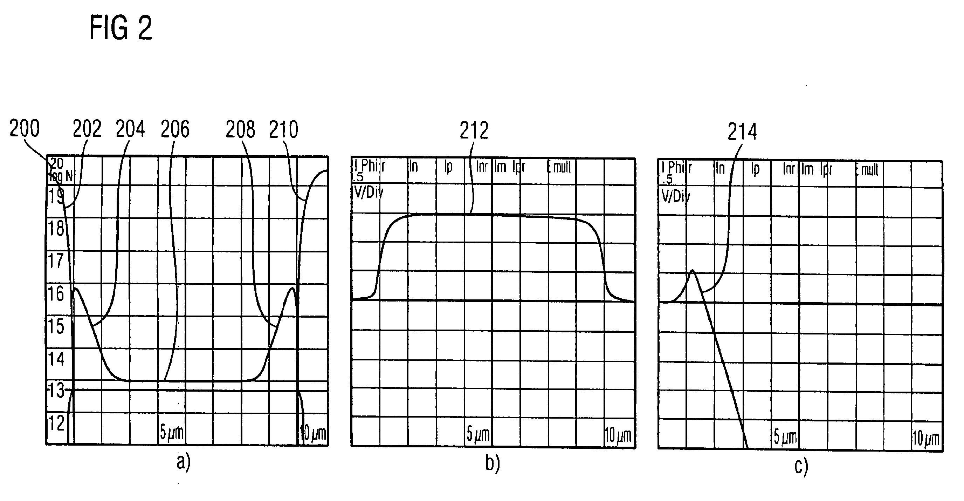

Fig. 2a shows an exemplary dopant profile 200 of a cross-section of the high-frequency switching transistor structure illustrated in Fig. 1 in the emitter area. On the abscissa of the diagram illustrated in Fig. 2a, the position of the surface 124 of the high-frequency switching transistor 100 illustrated in Fig. 1 is indicated. On the ordinate of the diagram illustrated in Fig. 2a, the dopant concentration is indicated in logarithmical illustration. Thus, it can be seen from Fig. 2a, that a semiconductor area with a high (such as more than a 10¹⁹ dopant atoms per cm³) dopant concentration is disposed in a left portion 202, by which the emitter area 130 illustrated in Fig. 1 is formed. A second portion 204 is bordering thereon, by which the third barrier area 128 illustrated in Fig. 1 is formed.

Further, from Fig. 2a the dopant concentration in the semiconductor area 114 which is lower in comparison to the third barrier area can be seen, which can be seen by a third portion 206 of the dopant profile 200 illustrated in Fig. 2a. The first barrier area 108 of the high-frequency switching transistor 100 illustrated in Fig. 1 has again a higher dopant concentration than the semiconductor area 114, which can be seen by a portion 208 of the illustrated dopant profile 200. Further, the collector area 104 can be seen in the dopant profile 200 in Fig. 2a by a portion 210.

If a sufficiently large negative base emitter voltage is applied to the base contact (such as -3 volt), almost the whole base area (such as the semiconductor area 114 illustrated in Fig. 1) becomes charge carrier free. The resulting potential in the semiconductor area 114 is now determined by the space charge in the p- and n-barrier areas.

Fig. 2b shows the potential curve in the blocking case for a specific collector emitter dopant profile, as it is illustrated in Fig. 2a, (i.e. when applying the blocking voltage between the base area and emitter area) without applying a voltage between the collector area 104 illustrated in Fig. 1 and the emitter area 130 (i.e. V_{CE} = 0 volt). Thus, the two highly p-doped diffusion profiles (i.e. the first barrier area 108 as well as the third barrier area 128) generate in the potential curve each a barrier against electron emission into the base area (particularly in the semiconductor area 114), which has a blocking potential of 1.5 volt with regard to the emitter area 130 at a collector-emitter voltage of 0 volt. At high positive collector-emitter voltages, it is reduced on the left (i.e. at the emitter area 130), and in negative collector emitter voltages on the right (i.e. near the collector area 104).

In Fig. 2c, a collector emitter voltage of 15 volt (i.e. V_{CE} = 15 V) is assumed, whereby it can be seen that the blocking potential is already almost reduced, but a rest potential of about 0.5 V still exists in the portion 214. Thereby, however, the blocking potential is still so effective that no remarkable current flows between the collector area 104 and the emitter area 130.

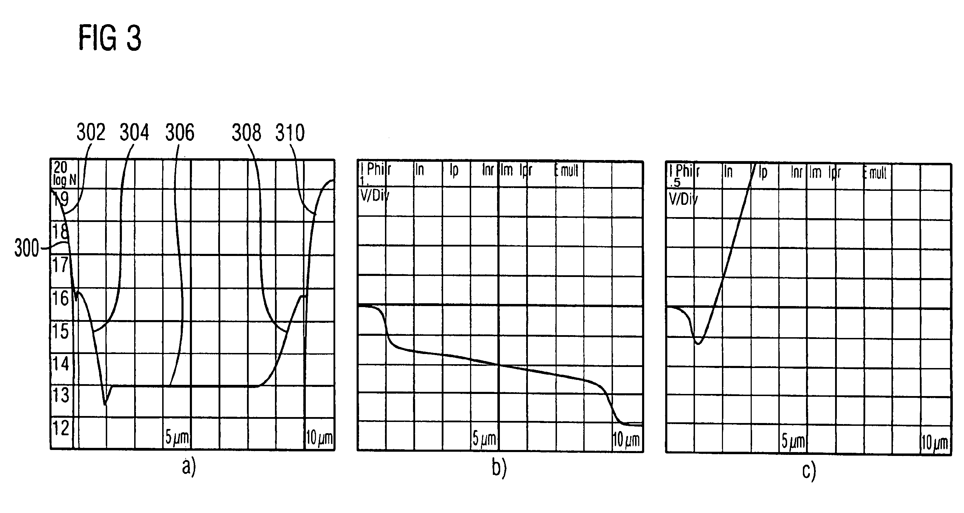

Fig. 3a shows an exemplary dopant profile 300 of a cross section of the high-frequency switching transistor 100 illustrated in Fig. 1 in the area of the base area 122. Thereby, again, the base area 122 can be seen by a portion 302 of the dopant profile 300, the second barrier area by a second portion 304, the semiconductor area 114 by a third portion 306, the first barrier area 108 by a fourth portion 308 as well as the collector area 104 by a fifth portion 310 of the dopant profile 300. When applying the negative base emitter voltage for blocking the high-frequency switching transistor, a potential curve as it is illustrated in Fig. 3b results in the base area. Thereby, again a negative voltage of -3 volt is applied between the base area 122 and the emitter area 130. At a voltage of 0 volt between the collector area 104 and the emitter area 130, thus, electrons can leave the base area (i.e. particularly the semiconductor area 114) to the right and holes to the left. This holds also true for all positive collector-emitter voltages. Thus, when applying a negative voltage at the collector area 104 (see Fig. 3c), a potential barrier remains in front of the base area 122, which prevents a reflow of the holes into the base (i.e. the second barrier area 120 as well as the semiconductor area 114).

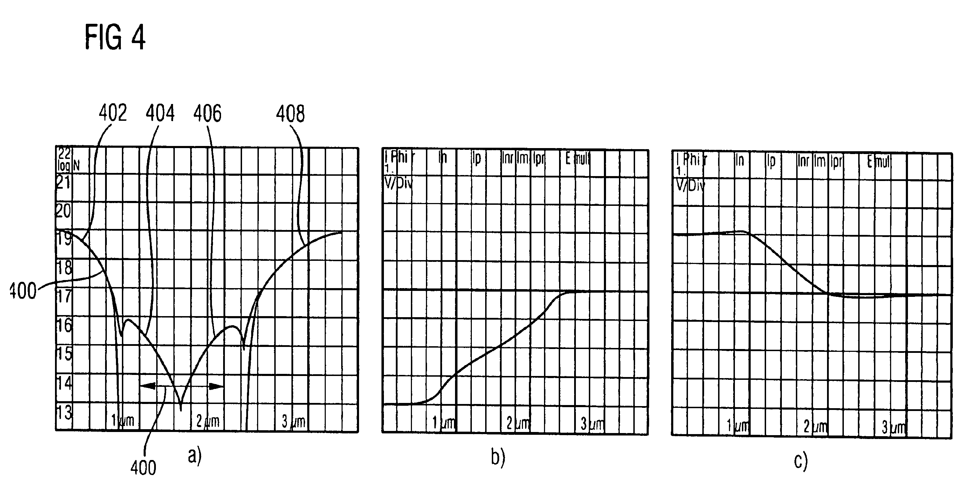

Fig. 4 shows a diagram of an exemplary dopant profile 400 and two diagrams with potential curves between the emitter area 130 and the base area 122. In Fig. 4a, a curve of a dopant concentration is illustrated by the dopant profile 400. Thereby, a position of the emitter area 310 can be seen from the dopant profile 400 by a first portion 402, the position of the third barrier area 128 by a second portion 404, the position of the second area by a third portion 406 as well as a position of the base area 122 by a fourth portion 408 of the dopant profile 400. Thereby, a cathode-anode distance 410 is chosen with approximately 1.5 µm so short that a potential barrier (i.e. a blocking potential between the third barrier area 128 and the second barrier area 120) is reduced almost fully at small positive voltages between the base area 122 and the emitter area 130. Such a potential curve can be seen in Fig. 4c.

A potential curve with an applied blocking voltage of, for example, -3 volt between the base area and the emitter area is illustrated in Fig. 4b. By such a reduction of the potential barrier already at small positive voltages (such as +2.5 V) between the base area and the emitter area, a turn-on process with only a low turn-on delay of less than for example 1 ns results. Therefrom results a significant acceleration of the switching behavior compared to previous high-frequency switching transistors. A lower limit for the emitter-base distance results from the requirement that the breakdown voltage of the emitter-base diode has to be higher than the bias voltage in the off-state (i.e. the blocking voltage of about -3 volt). A minimal distance between the base area and the emitter area results then in about 0.1 µm. Thus, it can be seen that the embodiment of the inventive high-frequency switching transistor described herein enables a significant shrink of the transistor.

A limit of the shrink is achieved when a collector-base breakdown voltage becomes smaller than the collector emission threshold voltage. In the case of a 20 Volt transistor (i.e. a collector emission threshold voltage of 20 volt), this is for example the case at about 0.8 µm base collector distance. In this case, the emission barriers (i.e. the first barrier area, the second barrier area as well as the third barrier area) should be significantly flatter and doped higher than illustrated in Fig. 1. A negative consequence of a shrink is, however, that nonlinearities in the forward case increase and that therefore the control current has to increase about reversely proportional to the square of a shrink. In the boundary case, an increase of the control current of 0.1 mA to 10 mA results.

An increase of the control current is limited by the limit of trench etching and is thus currently limited to a maximum of 100 µm trench depth. Thereby, a significant lowering of the control current to up to 1 µA can be achieved. A negative consequence of increasing the control current is the deceleration of the switching procedure and an increase of the production cost.

As an alternative to the so far described npn bipolar transistor, a pnp transistor can also be realized. This pnp transistor is formed by a swapping the p- and n-doped areas, and also swapping the conductivity type of all doped areas. The function of the pnp transistor can be described in the same way, when respectively a role of the electrons and holes is swapped. Due to a higher mobility of the electrons, which are now the minority charge carriers, significant performance deteriorations result in the on-state. Thus, the pnp transistor requires higher currents to obtain the same resistance, wherein, however, stronger harmonics are generated at the same time. The off state of the pnp transistor suffers no significant restrictions.

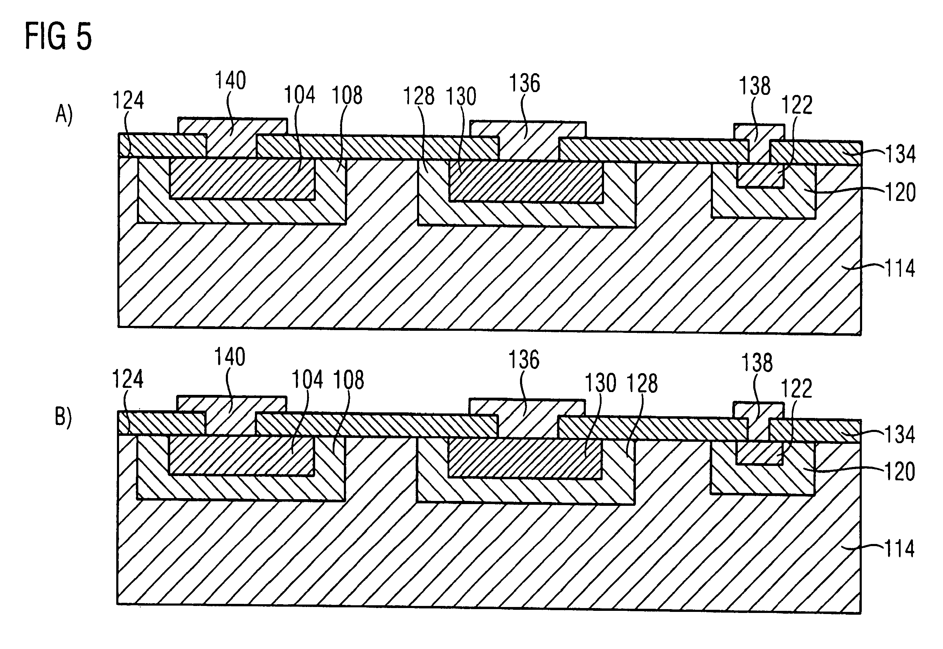

Lateral transistors can also be realized with the described barrier structures. Therefore, a further embodiment of an npn high-frequency switching transistor is illustrated in Fig. 5a. In contrary to the vertical structure of the high-frequency switching transistor 100 illustrated in Fig. 1, which provides a vertically placed position of the collector area 104 under the emitter area 130, the collector area 104 as well as the first barrier area 108 bordering on the collector area 104 are disposed such that they mostly terminate in a flush way with the surface 124. Therefore, the base area 122, the emitter area 130 as well as the collector area 104 are disposed horizontally at about the same height, wherein in this case the semiconductor area 114 can be formed by the substrate 102. Further, the second barrier area 120 forms a hole barrier, while the first barrier area 108 as well as a third barrier area 128 form an electron barrier.

Fig. 5b shows a lateral pnp transistor, which is constructed analogous to the npn transistor illustrated in Fig. 5a. In difference to the transistor illustrated in Fig. 5a, however, the two conductivity types of the respective area are swapped. Thus, the first barrier area 108 as well as the third barrier area 128 form a hole barrier, while the second barrier area 120 forms an electron barrier.

The two variations illustrated in Fig. 5, however, are not suitable for the operation in the on-state, since they have no limited injection area. In discrete transistors, this causes already bad parameters. In integrated circuits, they effect couplings between blocked and switched-on transistors, which are most unwanted. Since lateral transistors, however, can be produced particularly easily and have good properties in the off-state, they can be used in applications which only use the off-state (such as in antenna lightning protection). The lightning protection consists of the fact that voltage of any polarity, whose amount is higher than the collector emitter threshold voltage makes the transistor conductive. Loads with high-frequency voltage amplitudes already at low bias voltage in blocking direction no longer have any effect.

In summary, it may be said that by inserting hole injection barriers into the base contact of npn bipolar transistors as well as an electron injection barrier in the collector it can be avoided that the collector base diode becomes conductive at flow polarization. In pnp bipolar transistors, hole emission barriers are swapped against electron emission barriers and vice versa.

Thus, an electron emission barrier results by a weakly doped p-layer bordering on a highly n-doped contact area and a hole emission barrier by a weakly n-doped layer bordering on a highly p-doped contact area. The n⁺pn⁺ dopant profile of a transistor is replaced by a n⁺pIpn⁺ dopant profile with an almost undoped I zone in the middle, the pp⁺ base contact is replaced by an Inp⁺ dopant profile.

### Reference Number List

- 100: High-frequency switching transistor
- 102: Substrate
- 104: collector area
- 106: surface of the collector area
- 108: first barrier area
- 110: central area of the high-frequency switching transistor
- 112: surface of the barrier area 108
- 114: semiconductor area
- 116: portion of a surface of the semiconductor area 114
- 118: surface of the semiconductor area 114
- 120: second barrier area
- 122: base area
- 124: surface
- 126: further portion of the surface 118 of the semiconductor area 114
- 128: third barrier area
- 130: emitter area
- 132: distance between collector area 104 and emitter area 130
- 134: isolating cover layer
- 136: emitter contacting area
- 138: base contacting area
- 140: collector contacting area
- 142: boundary structure
- 144: lateral extension
- 146: contacting structure
- 148: conductive area of the contacting structure 146
- 150: isolating portion of the contacting structure 146
- 152: predefined distance between the second barrier area 120 and the third barrier area 128
- 200: dopant profile
- 202: first portion of the dopant profile 200
- 204: second portion of the dopant profile 200
- 206: third portion of the dopant profile 200
- 208: fourth portion of the dopant profile 200
- 210: fifth portion of the dopant profile 200
- 212: blocking potential
- 214: remaining blocking potential
- 300: dopant profile
- 302: first portion of the dopant profile 300
- 304: second portion of the dopant profile 300
- 306: third portion of the dopant profile 300
- 308: fourth portion of the dopant profile 300
- 310: fifth portion of the dopant profile 300
- 400: dopant profile
- 402: first portion of the dopant profile 400
- 404: second portion of the dopant profile 400
- 406: third portion of the dopant profile 400
- 408: fourth portion of the dopant profile 400
- 410: emitter base distance

## Claims

1. High-frequency switching transistor (100) comprising:
a collector area (104), which has a first conductivity type;
a first barrier area (108) bordering on the collector area (104), which has a second conductivity type which differs from the first conductivity type;
a semiconductor area (114) bordering on the first barrier area (108), which has a dopant concentration which is lower than a dopant concentration of the first barrier area (108) or equal to zero;
a second barrier area (120) bordering on a semiconductor area (114), which has a first conductivity type;
a base area (122) bordering on the second barrier area (120), which has the second conductivity type;
a third barrier area (128) bordering on the semiconductor area (114), which has the second conductivity type and a higher dopant concentration than the semiconductor area (114); and
an emitter area (130) bordering on the third barrier area (128), which has the first conductivity type.

2. High-frequency switching transistor (100) according to claim 1, wherein a material with the first conductivity type is an n-doped semiconductor material and a material with the second conductivity type is a p-doped semiconductor material.

3. High-frequency switching transistor (100) according to claim 1 or 2, wherein the second barrier area (120) is bordering on the third barrier area (128) or is disposed in a predetermined distance to the third barrier area (128).

4. High-frequency switching transistor (100) according to claim 3, wherein the predefined distance has a value of at most 20 µm.

5. High-frequency switching transistor (100) according to one of claims 1 to 4, wherein the first barrier area (108), the second barrier area (120) or the third barrier area (128) have a dopant concentration between 10¹⁵ and 10¹⁸ dopant atoms per cm³.

6. High-frequency switching transistor (100) according to claim 5, wherein the first barrier area (108), the second barrier area (120) or the third barrier area (128) have a dopant concentration between 10¹⁶ and 10¹⁷ dopant atoms per cm³.

7. High-frequency switching transistor (100) according to one of claims 1 to 6, wherein the semiconductor area (114) has a dopant concentration which is smaller than 10¹⁴ dopant atoms per cm³.

8. High-frequency switching transistor (100) according to one of claims 1 to 7, wherein the collector area (104), the base area (122) or the emitter area (130) have a dopant concentration which is higher or equal to 10¹⁹ dopant atoms per cm³.

9. High-frequency switching transistor (100) according to one of claims 1 to 8, wherein the first barrier area (108), the second barrier area (120) or the third barrier area (128) has a thickness which lies within a range of values between 0.1 µm and 2 µm.

10. High-frequency switching transistor (100) according to claim 9, wherein the first barrier area (108), the second barrier area (120) or the third barrier area (128) has a thickness which lies within a range of values between 0.2 µm and 1 µm.

11. High-frequency switching transistor (100) according to one of claims 1 to 10, wherein the base area (122) and the emitter area (130) are formed in a substrate and are disposed mainly laterally next to each other.

12. High-frequency switching transistor (100) according to one of claims 1 to 11, wherein the collector area (104) and the emitter area (130) are formed in a substrate and disposed mainly above one another.

13. High-frequency switching transistor (100) according to claim 12, wherein the semiconductor area (114) has a thickness which lies within a range of values between 4 µm and 10 µm.

14. High-frequency switching transistor (100) according to claim 13, wherein the semiconductor area (114) has a thickness which lies within a range of values between 5 µm and 8 µm.

15. High-frequency switching transistor (100) according to one of claims 13 or 14, wherein a boundary structure (142) is arranged to define a lateral extension (144) of the semiconductor area (114), the second barrier area (120) and the third barrier area (128).

16. High-frequency switching transistor (100) according to claim 15, wherein the boundary structure (142) has an isolating material.

17. High-frequency switching transistor (100) according to claim 15 or 16, wherein the lateral extension (144) of the semiconductor area (114), the second barrier area (120) and the third barrier area (128) lies within a range of values between 20 µm and 200 µm.

18. High-frequency switching transistor (100) according to one of claims 15 to 17, wherein the semiconductor area (114) has a square area, wherein the square area is disposed in parallel to a main area of the first barrier area (108) and has a square area side edge which is maximally the lateral extension (144).

19. High-frequency switching transistor (100) according to one of claims 12 to 18, wherein the collector area (104) can be contacted electrically conductively via a contact point of a contacting structure (146), wherein the contact structure (140) is disposed higher over the collector area (104) than a boundary area between the second barrier area (120) and the base area (122).

20. High-frequency switching transistor (100) according to claim 19, wherein the contacting structure (146) comprises at least a portion of an isolating material.

21. High-frequency switching transistor (100) according to one of claims 12 to 20, wherein the collector area is disposed on a substrate (102) which comprises a semi-isolating material.

22. High-frequency circuit, comprising:
a switch with a high-frequency switching transistor according to one of claims 1 to 21; and
a control circuit, which is formed to open or close the switch depending on a control signal, wherein the control means is formed to apply a negative switching voltage between the base area (122) and the emitter area (130) for closing the switch.

23. High-frequency circuit according to claim 22, wherein a circuit input can be coupled with a high-frequency source, wherein a voltage signal can be supplied from the high-frequency source, which has a high-frequency voltage amplitude and wherein the switching voltage is smaller or equal to half the high-frequency voltage amplitude.

## Patentansprüche

1. Hochfrequenzschalttransistor (100), der folgende Merkmale aufweist:
einen Kollektorbereich (104), der einen ersten Leitfähigkeitstyp aufweist;
einen ersten Barrierebereich (108), der an den Kollektorbereich (104) angrenzt, der einen zweiten Leitfähigkeitstyp aufweist, der sich von dem ersten Leitfähigkeitstyp unterscheidet;
einen Halbleiterbereich (114), der an den ersten Barrierebereich (108) angrenzt, der eine Dotiermittelkonzentration aufweist, die geringer ist als eine Dotiermittelkonzentration des ersten Barnerebereichs (108) oder gleich Null;
einen zweiten Barrierebereich (120), der an einen Halbleiterbereich (114) angrenzt, der einen ersten Leitfähigkeitstyp aufweist;
einen Basisbereich (122), der an den zweiten Barrierebereich (120) angrenzt, der den zweiten Leitfähigkeitstyp aufweist;
einen dritten Barrierebereich (128), der an den Halbleiterbereich (114) angrenzt, der den zweiten Leitfähigkeitstyp und eine höhere Dotiermittelkonzentration als die Halbleiterbereich (114) aufweist; und
einen Emitterbereich (130), der an den dritten Barrierebereich (128) angrenzt, der den ersten Leitfähigkeitstyp aufweist.

2. Hochfrequenzschalttransistor (100) gemäß Anspruch 1, bei dem ein Material mit dem ersten Leitfähigkeitstyp ein n-dotiertes Halbleitermaterial ist und ein Material mit dem zweiten Leitfähigkeitstyp ein p-dotiertes Halbleitermaterial ist.

3. Hochfrequenzschalttransistor (100) gemäß Anspruch 1 oder 2, bei dem der zweite Barrierebereich (120) an den dritten Barrierebereich (128) angrenzt oder in einem vorbestimmten Abstand zu dem dritten Barrierebereich (128) angeordnet ist.

4. Hochfrequenzschalttransistor (100) gemäß Anspruch 3, bei dem der vordefinierte Abstand einen Wert von höchstens 20 µm aufweist.

5. Hochfrequenzschalttransistor (100) gemäß einem der Ansprüche 1 bis 4, bei dem der erste Barrierebereich (108), der zweite Barrierebereich (120) oder der dritte Barrierebereich (128) eine Dotiermittelkonzentration zwischen 10¹⁵ und 10¹⁸ Dotiermittelatomen pro cm³ aufweist.

6. Hochfrequenzschalttransistor (100) gemäß Anspruch 5, bei dem der erste Barrierebereich (108), der zweite Barrierebereich (120) oder der dritte Barrierebereich (128) eine Dotiermittelkonzentration zwischen 10¹⁶ und 10¹⁷ Dotiermittelatomen pro cm³ aufweist.

7. Hochfrequenzschalttransistor (100) gemäß einem der Ansprüche 1 bis 6, bei dem der Halbleiterbereich (114) eine Dotiermittelkonzentration aufweist, die geringer ist als 10¹⁴ Dotiermittelatome pro cm³.

8. Hochfrequenzschalttransistor (100) gemäß einem der Ansprüche 1 bis 7, bei dem der Kollektorbereich (104), der Basisbereich (122) oder der Emitterbereich (130) eine Dotiermittelkonzentration aufweist, die höher als oder gleich 10¹⁹ Dotiermittelatome pro cm³ ist.

9. Hochfrequenzschalttransistor (100) gemäß einem der Ansprüche 1 bis 8, bei dem der erste Barrierebereich (108), der zweite Barrierebereich (120) oder der dritte Barrierebereich (128) eine Dicke aufweist, die in einem Wertebereich zwischen 0,1 µm und 2 µm liegt.

10. Hochfrequenzschalttransistor (100) gemäß Anspruch 9, bei dem der erste Barrierebereich (108), der zweite Barrierebereich (120) oder der dritte Barrierebereich (128) eine Dicke aufweist, die in einem Wertebereich zwischen 0,2 µm und 1 µm liegt.

11. Hochfrequenzschalttransistor (100) gemäß einem der Ansprüche 1 bis 10, bei dem der Basisbereich (122) und der Emitterbereich (130) in einem Substrat gebildet sind und im Wesentlichen lateral nebeneinander angeordnet sind.

12. Hochfrequenzschalttransistor (100) gemäß einem der Ansprüche 1 bis 11, bei dem der Kollektorbereich (104) und der Emitterbereich (130) in einem Substrat gebildet sind und im Wesentlichen übereinander angeordnet sind.

13. Hochfrequenzschalttransistor (100) gemäß Anspruch 12, bei dem der Halbleiterbereich (114) eine Dicke aufweist, die in einem Wertebereich zwischen 4 µm und 10 µm liegt.

14. Hochfrequenzschalttransistor (100) gemäß Anspruch 13, bei dem der Halbleiterbereich (14) eine Dicke aufweist, die in einem Wertebereich zwischen 5 µm und 8 µm liegt.

15. Hochfrequenzschalttransistor (100) gemäß einem der Ansprüche 13 oder 14, bei dem eine Grenzstruktur (142) angeordnet ist, um eine laterale Ausdehnung (144) des Halbleiterbereichs (114), des zweiten Barrierebereichs (120) und des dritten Barrierebereichs (128) zu definieren.

16. Hochfrequenzschalttransistor (100) gemäß Anspruch 15, bei dem die Grenzstruktur (142) ein isolierendes Material aufweist.

17. Hochfrequenzschalttransistor (100) gemäß Anspruch 15 oder 16, bei dem die laterale Ausdehnung (144) des Halbleiterbereichs (114), des zweiten Barrierebereichs (120) und des dritten Barnerebereichs (128) in einem Wertebereich zwischen 20 µm und 200 µm liegt.

18. Hochfrequenzschalttransistor (100) gemäß einem der Ansprüche 15 bis 17, bei dem der Halbleiterbereich (114) einen quadratischen Bereich aufweist, wobei der quadratische Bereich parallel zu einem Hauptbereich des ersten Barrierebereichs (108) angeordnet ist und eine Quadratbereichseitenkante aufweist, die maximal die laterale Ausdehnung (144) ist.

19. Hochfrequenzschalttransistor (100) gemäß einem der Ansprüche 12 bis 18, bei dem der Kollektorbereich (104) elektrisch leitfähig kontaktiert werden kann über einen Kontaktpunkt einer Kontaktierungsstruktur (146), wobei die Kontaktstruktur (140) höher angeordnet ist über dem Kollektorbereich (104) als ein Grenzbereich zwischen dem zweiten Barrierebereich (120) und dem Basisbereich (122).

20. Hochfrequenzschalttransistor (100) gemäß Anspruch 19, bei dem die Kontaktierungsstruktur (146) zumindest einen Teil eines isolierenden Materials aufweist.

21. Hochfrequenzschalttransistor (100) gemäß einem der Ansprüche 12 bis 20, bei dem der Kollektorbereich auf einem Substrat (102) angeordnet ist, das ein halbisolierendes Material aufweist.

22. Hochfrequenzschaltung, die folgende Merkmale aufweist:
einen Schalter mit einem Hochfrequenzschalttransistor gemäß einem der Ansprüche 1 bis 21; und
eine Steuerschaltung, die gebildet ist, um den Schalter abhängig von einem Steuersignal zu öffnen oder zu schließen, wobei die Steuereinrichtung gebildet ist, um zum Schließen des Schalters eine negative Schaltungsspannung zwischen die Basisbereich (122) und die Emitterbereich (130) anzulegen.

23. Hochfrequenzschaltung gemäß Anspruch 22, bei der ein Schaltungseingang mit einer Hochfrequenzquelle gekoppelt sein kann, wobei ein Spannungssignal von der Hochfrequenzquelle bereitgestellt werden kann, die eine Hochfrequenzspannungsamplitude aufweist, und wobei die Schaltspannung geringer ist als oder gleich ist wie die Hälfte der Hochfrequenzspannungsamplitude.

## Revendications

1. Transistor de commutation haute fréquence (100) comprenant :
une zone de collecteur (104) qui présente un premier type de conductivité ;
une première zone de barrière (108) adjacente à la zone de collecteur (104), qui présente un deuxième type de conductivité qui diffère du premier type de conductivité ;
une zone de semi-conducteur (114) adjacente à la première zone de barrière (108), qui présente une concentration de dopant qui est inférieure à la concentration de dopant de la première zone de barrière (108) ou égale à zéro ;
une deuxième zone de barrière (120) adjacente à une zone de semi-conducteur (114), qui présente un premier type de conductivité ;
une zone de base (122) adjacente à une deuxième zone de barrière (120), qui présente le deuxième type de conductivité ;
une troisième zone de barrière (128) adjacente à la zone de semi-conducteur (114), qui présente le deuxième type de conductivité et une concentration de dopant supérieure à la zone de semi-conducteur (114) ; et
une zone d'émetteur (130) adjacente à la troisième zone de barrière (128), qui présente le premier type de conductivité.

2. Transistor de commutation haute fréquence (100) selon la revendication 1, dans lequel un matériau avec un premier type de conductivité est un matériau semi-conducteur dopé de type n et un matériau avec un deuxième type de conductivité est un matériau semi-conducteur dopé de type p.

3. Transistor de commutation haute fréquence (100) selon la revendication 1 ou 2, dans lequel la deuxième zone de barrière (120) est adjacente à la troisième zone de barrière (128) ou est disposée à une distance prédéterminée de la troisième zone de barrière (128).

4. Transistor de commutation haute fréquence (100) selon la revendication 3, dans lequel la distance prédéterminée a une valeur de tout au plus 20 µm.

5. Transistor de commutation haute fréquence (100) selon l'une des revendications 1 à 4, dans lequel la première zone de barrière (108), la deuxième zone de barrière (120) ou la troisième zone de barrière (128) présentent une concentration de dopant comprise entre 10¹⁵ et 10¹⁸ atomes de dopant par cm³.

6. Transistor de commutation haute fréquence (100) selon la revendication 5, dans lequel la première zone de barrière (108), la deuxième zone de barrière (120) ou la troisième zone de barrière (128) présentent une concentration de dopant comprise entre 10¹⁶ et 10¹⁷ atomes de dopant par cm³.

7. Transistor de commutation haute fréquence (100) selon l'une des revendications 1 à 6, dans lequel la zone de semi-conducteur (114) présente une concentration de dopant qui est inférieure à 10¹⁴ atomes de dopant par cm³.

8. Transistor de commutation haute fréquence (100) selon l'une des revendications 1 à 7, dans lequel la zone de collecteur (104), la zone de base (122) ou la zone d'émetteur (130) présentent une concentration de dopant qui est supérieure ou égale à 10¹⁹ atomes de dopant par cm³.

9. Transistor de commutation haute fréquence (100) selon l'une des revendications 1 à 8, dans lequel la première zone de barrière (108), la deuxième zone de barrière (120) ou la troisième zone de barrière (128) présentent une épaisseur qui se situe dans une plage de valeurs comprise entre 0,1 µm et 2 µm.

10. Transistor de commutation haute fréquence (100) selon la revendication 9, dans lequel la première zone de barrière (108), la deuxième zone de barrière (120) ou la troisième zone de barrière (128) présentent une épaisseur qui se situe dans une plage de valeurs comprise entre 0,2 µm et 1 µm.

11. Transistor de commutation haute fréquence (100) selon l'une des revendications 1 à 10, dans lequel la zone de base (122) et la zone d'émetteur (130) sont formées dans un substrat et sont disposées principalement latéralement l'une à côté de l'autre.

12. Transistor de commutation haute fréquence (100) selon l'une des revendications 1 à 11, dans lequel la zone de collecteur (104) et la zone d'émetteur (130) sont formées dans un substrat et disposées principalement l'une au-dessus de l'autre.

13. Transistor de commutation haute fréquence (100) selon la revendication 12, dans lequel la zone de semi-conducteur (114) présente une épaisseur qui se situe dans une plage de valeurs comprise entre 4 µm et 10 µm.

14. Transistor de commutation haute fréquence (100) selon la revendication 13, dans lequel la zone de semi-conducteur (114) présente une épaisseur qui se situe dans une plage de valeurs comprise entre 5 µm et 8 µm.

15. Transistor de commutation haute fréquence (100) selon l'une des revendications 13 ou 14, dans lequel est disposée une structure de délimitation (142) destinée à définir une extension latérale (144) de la zone de semi-conducteur (114), de la deuxième zone de barrière (120) et de la troisième zone de barrière (128).

16. Transistor de commutation haute fréquence (100) selon la revendication 15, dans lequel la structure de délimitation (142) présente un matériau isolant.

17. Transistor de commutation haute fréquence (100) selon la revendication 15 ou 16, dans lequel l'extension latérale (144) de la zone de semi-conducteur (114), de la deuxième zone de barrière (120) et de la troisième zone de barrière (128) se situe dans la plage de valeurs comprise entre 20 µm et 200 µm.

18. Transistor de commutation haute fréquence (100) selon l'une des revendications 15 à 17, dans lequel la zone de semi-conducteur (114) présente une zone carrée, dans lequel la zone carrée est disposée en parallèle par rapport à une zone principale de la première zone de barrière (108) et présente un bord latéral de zone carrée qui est au maximum l'extension latérale (144).

19. Transistor de commutation haute fréquence (100) selon l'une des revendications 12 à 18, dans lequel la zone de collecteur (104) peut être mise en contact de manière électro-conductrice à travers d'un point de contact d'une structure de contact (146), dans lequel la structure de contact (140) est disposée plus haut au-dessus de la zone de collecteur (104) qu'une zone de délimitation entre la deuxième zone de barrière (120) et la zone de base (122).

20. Transistor de commutation haute fréquence (100) selon la revendication 19, dans lequel la structure de contact (146) comprend au moins une partie d'un matériau isolant.

21. Transistor de commutation haute fréquence (100) selon l'une des revendications 12 à 20, dans lequel la zone de collecteur est disposée sur un substrat (102) qui comprend un matériau semi-isolant.

22. Circuit haute fréquence, comprenant :
un commutateur avec un transistor de commutation haute fréquence selon l'une des revendications 1 à 21 ; et
un circuit de commande qui est formé de manière à ouvrir ou fermer le commutateur en fonction d'un signal de commande, où le moyen de commande est formé de manière à appliquer une tension de commutation négative entre la zone de base (122) et la zone d'émetteur (130) pour fermer le commutateur.

23. Transistor de commutation haute fréquence (100) selon la revendication 22, dans lequel une entrée de circuit peut être couplée à une source de haute fréquence, dans lequel un signal de tension peut être fourni par la source de haute fréquence, qui présente une amplitude de tension haute fréquence et dans lequel la tension de commutation est inférieure ou égale à la moitié de l'amplitude de tension haute fréquence.
